# EUROPÄISCHE PATENTSCHRIFT

(11) **EP 1 480 340 B1**
(45) Veröffentlichungstag und Bekanntmachung des Hinweises auf die Patenterteilung: **25.03.2009**
(21) Anmeldenummer: 04011892.9
(22) Anmeldetag: 19.05.2004
(51) Int. Cl.: H05K 7/14, H03K 17/16

(54) **Steuereinrichtung**
Control device
Appareil de commande

(30) Priorität: 23.05.2003 DE 10325371
(43) Veröffentlichungstag der Anmeldung: 24.11.2004
(60) Teilanmeldung: 08000731.3
(73) Patentinhaber: AFL Europe GmbH, 72636 Frickenhausen (DE)
(72) Erfinder: Flock, Horst Mathias, 72766 Reutlingen (DE)
(74) Vertreter: Beck, Jürgen

(56) Entgegenhaltungen:
- US-A- 5 623 399
- US-A- 6 075 331
- US-A1- 2002 195 286

## Beschreibung

Die Erfindung betrifft eine Steuerung für an einem elektrischen Versorgungsnetz eines Kraftfahrzeugs angeschlossene Aggregate, umfassend einen Steuersignalgenerator zur Erzeugung eines pulsweitenmodulierten Steuersignals, eine Leistungsendstufe mit mindestens einem Leistungsschalter zum Versorgen der jeweiligen Last, wobei der Leistungsschalter durch das an einem Steuereingang desselben anliegende Steuersignal pulsweitenmoduliert ansteuerbar ist und zur Verbindung mit dem Versorgungsnetz sowie mit der Last Anschlüsse aufweist.

Derartige Steuereinrichtungen sind aus der US 6,075,331 bekannt. Bei diesen besteht insbesondere dann, wenn große Ströme fließen sollen, das Problem, den Schaltungsaufbau so auszuführen, dass einerseits möglichst geringe Leitungsinduktivitäten und andererseits auch möglichst geringe elektrische Übergangswiderstände auftreten.

Diese Aufgabe wird bei einer Steuerung der eingangs genannten Art erfindungsgemäß dadurch gelöst, dass in der mindestens einen Leistungsendstufe ein netzseitiger Stromanschlussträger und ein lastseitiger Stromanschlussträger vorgesehen sind und dass mindestens ein Leiterstück jedes Leistungsschalters durch jeweils eine durch Klemmbacken eines Klemmkörper gebildet Klemmverbindung mit einem der Stromanschiussträger verbunden ist.

Der Vorteil dieser Lösung ist darin zu sehen, daß durch das Vorsehen der Stromanschlußträger einerseits die Möglichkeit geschaffen ist, mit geringen Widerständen große Ströme fließen zu lassen und andererseits durch das Vorsehen der Klemmverbindung für den Anschluß des Leiterstücks an einen der Stromanschlußträger eine für hohe Ströme geeignete sichere elektrische Verbindung zwischen dem Stromanschlußträger und dem Leiterstück des Leistungsschalters hergestellt werden kann.

Der Leistungsschalter kann beispielsweise zwei Paare von Leiterstücken aufweisen, die über eine Klemmverbindung mit dem jeweiligen Stromanschlußträger verbindbar sind.

Üblicherweise umfaßt ein Leistungsschalter als weiteren Anschluß einen Anschlußflansch, welcher vorteilhafterweise mit dem jeweiligen anderen Stromanschlußträger verbunden ist.

Vorzugsweise ist dabei der Anschlußflansch an den jeweils anderen Stromanschlußträger angepreßt anliegt.

Insbesondere wird ein derartiges angepreßtes Anlegen des Anschlußflansches an dem jeweils anderen Stromanschlußträger durch ein die Preßkraft ausübendes Spannelement oder Schraubelement erreicht.

Um die Leistungsschalter mit möglichst geringer Leitungsinduktivität anordnen zu können, ist vorzugsweise vorgesehen, daß die Klemmverbindung eine dem anderen Stromanschlußträger zugewandte Aufnahme für das Leiterstück aufweist.

Ferner sind - insbesondere um eine räumlich kompakte Bauweise zu erreichen - der netzseitige Stromanschlußträger und der lastseitige Stromanschlußträger parallel zueinander verlaufend angeordnet.

Dies ist besonders vorteilhaft, wenn nicht nur ein Leistungsschalter, sondern eine Vielzahl von parallelgeschalteten Leistungsschaltern vorgesehen ist, welche in einer parallel zu den Stromanschlußträgern verlaufenden Reihe angeordnet sind.

Um eine ausreichend gute Entstörung der Steuereinrichtung zu erreichen, ist bei einer bevorzugten Ausführungsform ein masseseitiger Stromanschlußträger vorgesehen, wobei zwischen dem netzseitigen Stromanschlußträger und dem masseseitigen Stromanschlußträger mindestens ein Entstörkondensator vorgesehen ist, welcher dazu dient, Spannungsspitzen, die auf das Versorgungsnetz zurückwirken, zu glätten.

Vorzugsweise ist dabei der mindestens eine Entstörkondensator so ausgebildet, daß er zwei Kondensatoranschlüsse aufweist, von denen mindestens einer als Leiterstück ausgebildet und durch mindestens eine Klemmverbindung mit einem der Stromanschlußträger verbunden ist.

Auch damit ist eine einfache und kompakte Montage des mindestens einen Entstörkondensators möglich.

Vorzugsweise ist dabei auch den andere Kondensatoranschluß als Leiterstück ausgebildet und durch jeweils eine Klemmverbindung mit dem anderen der Stromanschlußträger verbunden.

Um eine möglichst optimale Entstörwirkung mit möglichst geringen Leitungsinduktivitäten zu erreichen, ist vorzugsweise vorgesehen, daß der netzseitige Stromanschlußträger und der masseseitige Stromanschlußträger im Abstand nebeneinanderliegend angeordnet sind, so daß die Möglichkeit besteht, die Entstörkondensatoren mit möglichst kurzen Leitungen mit den beiden Stromanschlußträgern zu verbinden.

Besonders günstig ist es dabei, wenn die Klemmverbindungen an den Stromanschlußträgern in einem Abstand angeordnet sind, weicher ungefähr einem Abstand der aus dem mindestens einen Entstörkondensator austretenden Leiterstücke entspricht. Damit besteht die Möglichkeit, die Leiterstücke des Entstörkondensators ohne große Leitungsinduktivitäten mit den Stromanschlußträgern zu verbinden.

Vorzugsweise sind der netzseitige Stromanschlußträger und der masseseitige Stromanschlußträger durch einen Isolierkörper gegeneinander elektrisch isoliert und insbesondere durch den Isolierkörper im Abstand gehalten.

Besonders vorteilhaft ist die erfindungsgemäße Konzeption hinsichtlich der vorgesehenen Entstörkondensatoren dann, wenn mehrere Entstörkondensatoren vorgesehen sind, da diese mehreren Entstörkondensatoren dann in einer zu den Stromanschlußträgern parallel verlaufenden Reihe angeordnet sind.

Darüber hinaus ist insbesondere dann, wenn die Lasten induktive Lasten sind, in der Steuereinrichtung ein masseseitiger Stromanschlußträger vorgesehen, wobei zwischen dem lastseitigen Stromanschlußträger und dem masseseitigen Stromanschlußträger mindestens eine Freilaufdiode vorgesehen ist, welche in der Lage ist, einen Freilaufstrom zwischen dem lastseitigen Stromanschlußträger und dem masseseitigen Stromanschlußträger fließen zu lassen.

Besonders günstig ist es dabei wenn die mindestens eine Freilaufdiode zwei Diodenanschlüsse aufweist und wenn mindestens einer der Diodenanschlüsse als Leiterstück ausgebildet und durch jeweils eine Klemmverbindung mit einem der Stromanschlußträger verbunden ist.

Vorzugsweise ist dabei der andere Diodenanschluß als Anschlußflansch ausgebildet und über diesen mit dem jeweils anderen Stromanschlußträger verbunden.

Zweckmäßigerweise ist dabei der Anschlußflansch mit dem Stromanschlußträger derart verbunden, daß der Anschlußflansch an dem jeweiligen Stromanschlußträger angepreßt anliegt.

Besonders vorteilhaft ist es, insbesondere um die mindestens eine Diode mit möglichst geringen Leitungsinduktivitäten anschließen zu können, wenn die Klemmverbindung eine dem anderen Stromanschlußträger zugewandte Aufnahme aufweist.

Besonders günstig ist es für eine kompakte Bauweise, wenn der lastseitige Stromanschlußträger und der masseseitige Stromanschlußträger parallel zueinander verlaufen.

Insbesondere dann, wenn große Ströme von den Freilaufdioden aufgenommen werden sollen, ist vorzugsweise eine Vielzahl von Freilaufdioden vorgesehen, welche in einer parallel zu den Stromanschlußträgern verlaufenden Reihe angeordnet sind.

Hinsichtlich der Ausbildung der Klemmverbindungen wurden im Zusammenhang mit den bisher beschriebenen Ausführungsbeispielen keine näheren Angaben gemacht.

So ist es besonders günstig, wenn die Klemmverbindung durch zwei Klemmbacken eines Klemmkörpers gebildet ist, so daß sich die Klemmverbindung sehr einfach durch den Klemmkörper mit seinen Klemmbacken realisieren läßt.

Diese Lösung ist konstruktiv besonders einfach dann realisierbar, wenn die Klemmbacken einstückig an dem Klemmkörper angeformt sind. Der Vorteil dieser Lösung ist insbesondere auch hinsichtlich der elektrischen Verbindung zu sehen, da beide Klemmbacken aufgrund ihrer einstückigen Verbindung mit dem Klemmkörper einen Strom ohne Übergangswiderstand zwischen Klemmbacken und Klemmkörper aufnehmen können.

Um derartige Klemmkörper besonders einfach und günstig herstellen zu können, ist vorzugsweise vorgesehen, daß der Klemmkörper durch einen Abschnitt einer Profilschiene gebildet ist, welche mindestens eine Nut aufweist und mit beiderseits der Nut angeordneten Nutwänden die Klemmbacken bildet.

Vorzugsweise ist insbesondere bei einer Vielzahl von Leistungsschaltern oder Entstörkondensatoren oder Freilaufdioden vorgesehen, daß jeder Stromanschlußträger mit einer Vielzahl von Klemmkörpern versehen ist.

Eine hinsichtlich der Ausführung besonders zweckmäßige Lösung sieht dabei vor, daß der Stromanschlußträger selbst als die Klemmkörper bildende Profilschiene ausgebildet ist.

Im Fall einer Vielzahl von Klemmkörpern als Teil der Profilschiene lassen sich diese Klemmkörper besonders einfach durch auf mindestens einer Seite der Nut angeordnete getrennte Nutwandabschnitte realisieren.

Diese Nutwandabschnitte können im Fall einer Profilschiene besonders einfach dadurch in der jeweiligen Nutwand quer zur Längsrichtung der Nut verlaufende Einschnitte gebildet werden.

Alternativ oder ergänzend zu der vorstehend beschriebenen erfindungsgemäßen Lösung ist bei einer Steuereinrichtung der eingangs beschriebenen Art erfindungsgemäß vorgesehen, daß eine Masseverbindung von dem Versorgungsnetz zu einem die Last aufweisenden Aggregat ausschließlich über die Leistungsendstufe der Steuereinrichtung geführt ist. Diese Ausbildung der erfindungsgemäßen Lösung hat den großen Vorteil, daß damit die Möglichkeit besteht, effizient Störungen im Bereich der Leistungsendstufe zu filtern und zu beseitigen, während bei einer direkten Masseverbindung zwischen dem Versorgungsnetz und dem Aggregat und einer Zweigverbindung für den Masseanschluß der Steuereinrichtung eine derartige effiziente Filterung und Entstörung nicht möglich ist.

Besonders günstig ist es, wenn die Masseverbindung über einen masseseitigen Stromanschlußträger der Steuereinrichtung geführt ist.

Eine vorteilhafte Lösung hierzu sieht vor, daß von dem Versorgungsnetz eine Masseleitung zum masseseitigen Stromanschlußträger und vom masseseitigen Stromanschlußträger eine Masseleitung zu dem die Last aufweisenden Aggregat geführt ist.

Weitere Merkmale und Vorteil der Erfindung sind Gegenstand der nachfolgenden Beschreibung sowie der zeichnerischen Darstellung einiger Ausführungsbeispiele.

In der Zeichnung zeigen:

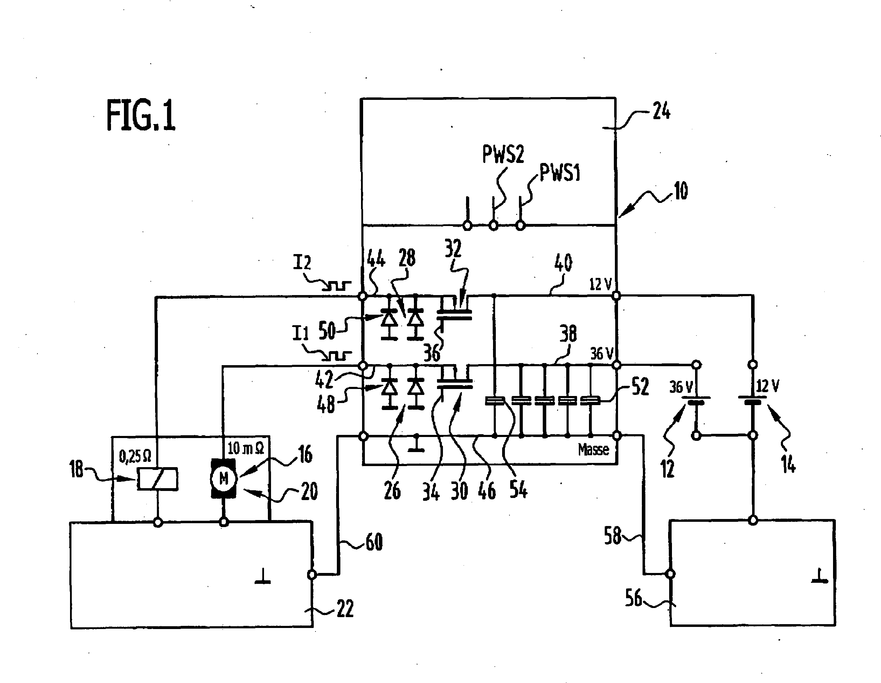

- Fig. 1: eine schematische Darstellung einer erfindungsgemäßen Steuereinrichtung, angeordnet zwischen fahrzeugseitigen Versorgungsnetzen und einem Aggregat eines Fahrzeugs;
- Fig. 2: eine schematische Darstellung einer vorteilhaften Ausführungsform einer erfindungsgemäßen Leistungsendstufe für eine Last;
- Fig. 3: eine räumliche ausschnittsweise Darstellung eines Schaltungsaufbaus der Schaltung gemäß Fig. 2;
- Fig. 4: eine Draufsicht in Richtung des Pfeils A in Fig. 3;
- Fig. 5: eine Darstellung eines lastseitigen Stromanschlußträgers mit Blick in Richtung des Pfeils A in Fig. 3;
- Fig. 6: eine Draufsicht auf den lastseitigen Stromanschlußträger in Richtung des Pfeils B in Fig. 5;
- Fig. 7: eine Ansicht des lastseitigen Stromanschlußträgers in Richtung des Pfeils C in Fig. 5;
- Fig. 8: eine Ansicht ähnlich Fig. 5 eines netzseitigen Stromanschlußträgers;
- Fig. 9: eine Ansicht ähnlich Fig. 6 des netzseitigen Stromanschlußträgers;
- Fig. 10: eine Ansicht ähnlich Fig. 7 des netzseitigen Stromanschlußträgers;
- Fig. 11: eine Ansicht ähnlich Fig. 5 eines masseseitigen Stromanschlußträgers;
- Fig. 12: eine Ansicht ähnlich Fig. 6 des masseseitigen Stromanschlußträgers und
- Fig. 13: eine Ansicht ähnlich Fig. 7 des masseseitigen Stromanschlußträgers.

Ein Ausführungsbeispiel einer als Ganzes mit 10 bezeichneten erfindungsgemäßen Steuereinrichtung ist beispielsweise mit einem ersten elektrischen Versorgungsnetz 12 und einem zweiten elektrischen Versorgungsnetz 14 eines zeichnerisch nicht dargestellten Kraftfahrzeugs verbunden und dient dazu, eine erste Last 16 und eine zweite Last 18 anzusteuern, wobei beispielsweise die erste Last 16 ein Anlassermotor eines Anlassers 20 für einen Verbrennungsmotor 22 des Kraftfahrzeugs ist und die zweite Last 18 ein Einrückmagnet des Anlassers 20.

Zum Betreiben der ersten Last 16 und der zweiten Last 18 ist die Steuereinrichtung 10 mit einem als Ganzes mit 24 bezeichneten Steuersignalgenerator versehen, welcher in der Lage ist, durch pulsweitenmodulierte Steuersignale PWS1 und PW2 sowohl eine erste Endstufe 26 zum Betreiben der ersten Last 16 am ersten Versorgungsnetz 12 als auch eine zweite Endstufe 28 zum Betreiben der zweiten Last 18 am zweiten Versorgungsnetz 14 anzusteuern, von denen jede einen durch Pulsweitenmodulation steuerbaren Strom 11 bzw. 12 zur Versorgung der ersten Last 16 bzw. der zweiten Last 18 liefert.

Zur Erzeugung des durch Pulsweitenmodulation gesteuerten Stroms 11 bzw. 12 umfaßt jede der Leistungsendstufen 26 bzw. 28 eine Vielzahl von parallelgeschalteten Leistungsschaltern 30 bzw. 32, die einen Steuereingang 34 bzw. 36 aufweisen, welcher durch den Steuersignalgenerator 24 mit den Steuersignalen PWS1 und PWS2 ansteuerbar ist, um mit diesen Leistungsschaltern 30 bzw. 32 einen von einem netzseitigen Stromanschlußträger 38 bzw. 40 zu einem lastseitigen Stromanschlußträger 42 bzw. 44 fließenden Strom durch Ein- und Ausschalten entsprechend den Steuersignalen PWS1 und PWS2 an den Steuereingängen 34 bzw. 36 steuern.

Darüber hinaus sind zwischen dem lastseitigen Stromanschlußträger 42 bzw. 44 und Masse an einem masseseitigen Stromanschlußträger 46 der Leistungsendstufen 26, 28 parallelgeschaltete Freilaufdioden 48 bzw. 50 vorgesehen, die einen beim Ausschalten der Leistungsschalter 30 bzw. 32 aufgrund einer Induktivität der jeweiligen Last 16 bzw. 18 auftretenden Freilaufstrom übernehmen.

Ferner sind in jeder der Leistungsendstufen 26 bzw. 28 parallelgeschaltete Entstörkondensatoren 52 bzw. 54 zwischen dem netzseitigen Stromanschlußträger 38 bzw. 40 und dem masseseitigen Stromanschlußträger 46 angeordnet.

Erfindungsgemäß ist der Verbrennungsmotor 22 nicht direkt mit einer Fahrzeugkarosserie 56 des Kraftfahrzeugs verbunden, um eine Masseverbindung zwischen dem ersten Netz 12 und dem zweiten Netz 14 herzustellen, sondern von der Fahrzeugkarosserie 56 ist eine Masseleitung 58 zu dem masseseitigen Stromanschlußträger 46 in der erfindungsgemäßen Steuereinrichtung 10 geführt und von dem masseseitigen Stromanschlußträger 46 eine Masseleitung 60 zu dem Verbrennungsmotor 22, so daß die Entstörkondensatoren 52 und 54 mit möglichst kurzen und somit eine geringe Induktivität aufweisenden Leitungsstrecken und ohne Streuinduktivität mit der jeweiligen Last 16 bzw. 18 verbunden sind, um eine möglichst optimale Wirkung der Entstörkondensatoren 52 bzw. 54 zu erreichen.

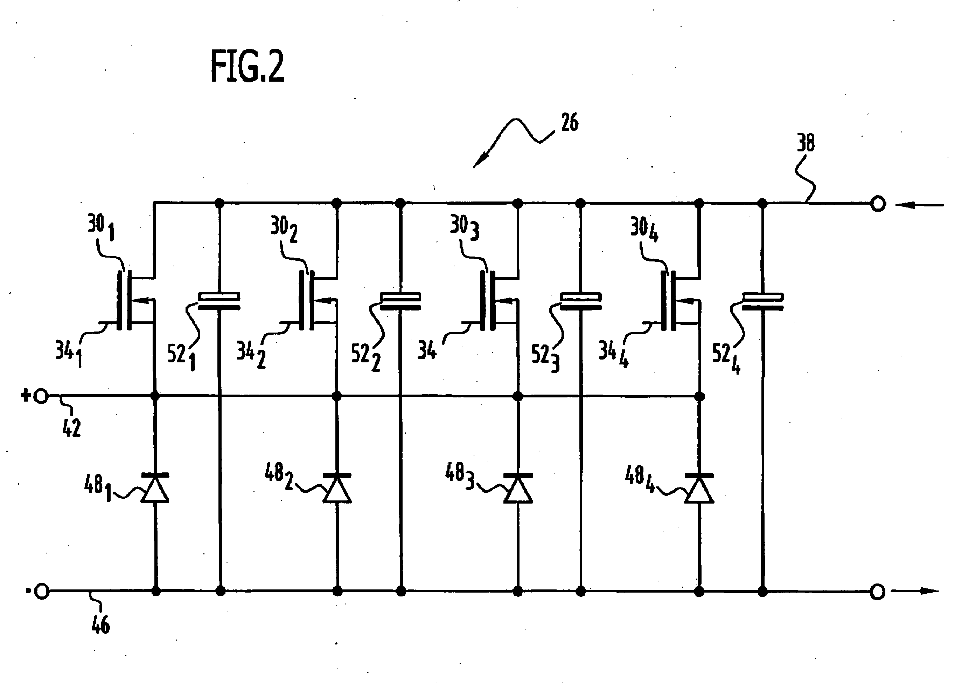

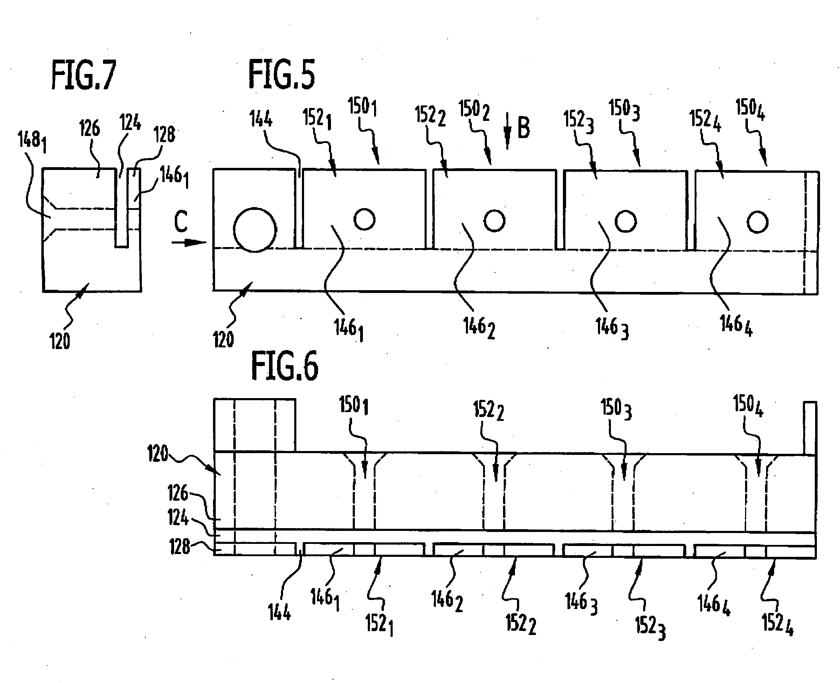

Der elektrische Aufbau einer derartigen Leistungsendstufe 26 bzw. 28 ist exemplarisch am Beispiel der Leistungsendstufe 26 in Fig. 2 bis Fig. 13 anhand eines Schaltbildes nochmals dargestellt, wobei die Leistungsendstufe 26 beispielsweise vier Leistungsschalter 30₁ bis 30₄, beispielsweise Halbleiterschalter, insbesondere Feldeffekttransistoren oder ähnliche Halbleiter, umfaßt, die über ihre Steuereingänge 34₁ bis 34₄ steuerbar sind.

Ferner sind beispielsweise jedem der Leistungsschalter 30₁bis 30₄ jeweils ein Entstörkondensator 52₁bis 52₄ zugeordnet, die - wie bereits dargelegt - mit dem netzseitigen Stromanschlußträger 38 und dem masseseitigen Stromanschlußträger 46 elektrisch verbunden sind.

Darüber hinaus ist beispielsweise auch jedem der Leistungsschalter 30₁ bis 30₄ eine eigene Freilaufdiode 48₁ bis 48₄ zugeordnet, welche jeweils zwischen dem lastseitigen Stromanschlußträger 42 und dem masseseitigen Stromanschlußträger 46 liegen.

Es ist aber auch denkbar, die Zahl der Entstörkondensatoren 42 und/oder die Zahl der Freilaufdioden 48 unabhängig von der Zahl der Leistungsschalter 30 zu wählen.

Da eine derartige Leistungsendstufe 26 mit großen Strömen und relativ hohen Schaltfrequenzen arbeitet, ist nicht nur die Verschaltung der einzelnen Bauteile 30, 48, 52 maßgebend, sondern auch deren körperliche und möglichst geringinduktive Anordnung relativ zueinander.

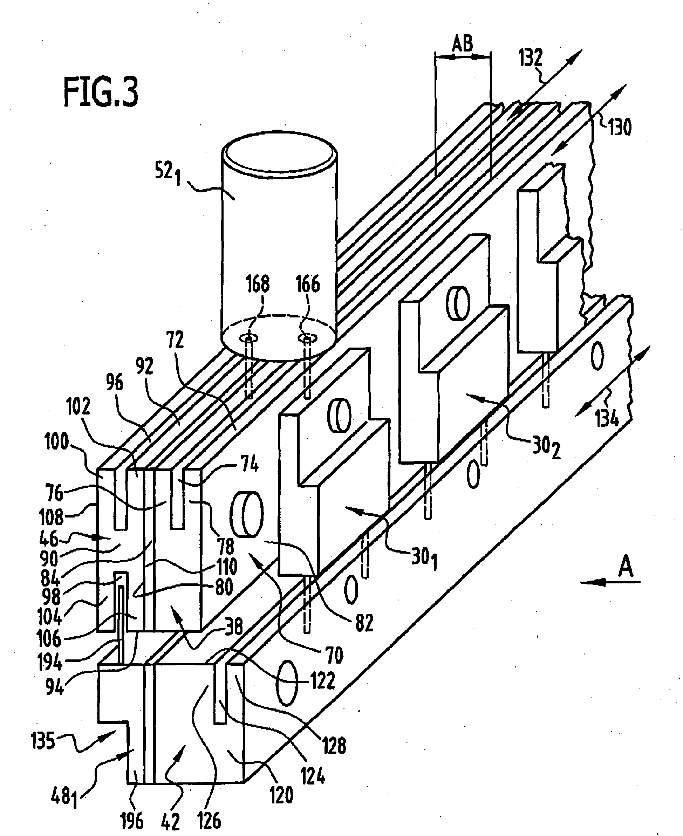

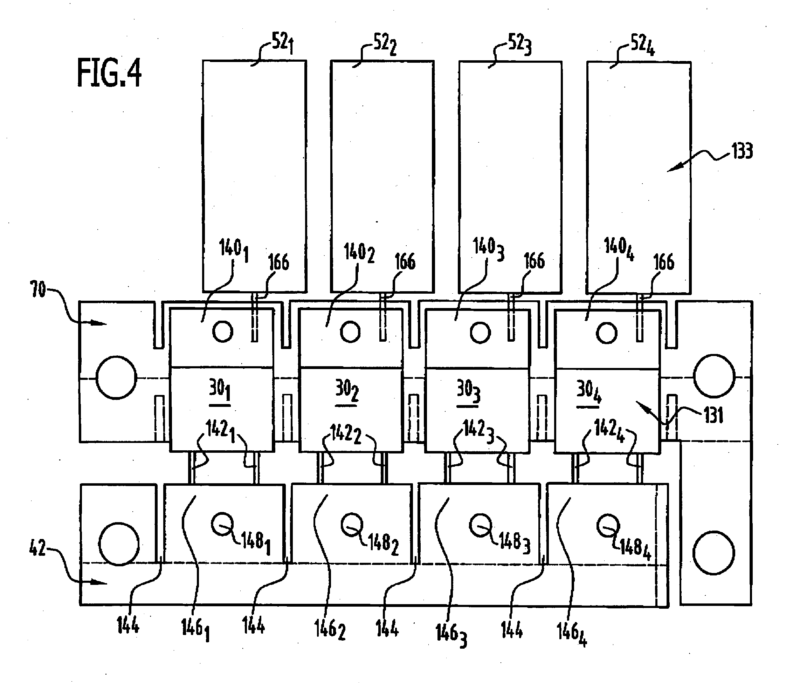

Wie in Fig. 3 und 4 dargestellt, ist der netzseitige Stromanschlußträger 38 als Profilschiene 70 ausgebildet, welche an einer Schmalseite 72 mit einer von dieser ausgehend in die Profilschiene 70 eintauchenden Nut 74 versehen ist, die beiderseits durch Nutwände 76, 78 begrenzt ist.

Ferner weist die Profilschiene 70 einander gegenüberliegende Breitseiten 80, 82 auf, wobei an der Breitseite 80 über einen Isolierkörper 84 abgestützt der masseseitige Stromanschlußträger 46 gehalten ist, welcher ebenfalls als Profilschiene 90 ausgebildet ist, von deren einander gegenüberliegenden Schmalseiten 92 und 94 ausgehend jeweils eine Nut 96 bzw. 98 eintaucht, die ihrerseits durch Nutwände 100, 102 bzw. 104, 106 begrenzt sind.

Die Profilschiene 90 ist dabei vorzugsweise so angeordnet, daß deren Breitseiten 108 bzw. 110 parallel zu den Breitseiten 80 und 82 verlaufen und beispielsweise die Breitseite 110 an dem Isolierkörper 84 anliegt.

Darüber hinaus ist auch der lastseitige Stromanschlußträger 42 als Profilschiene 120 ausgebildet, die ebenfalls eine von einer Schmalseite 122 ausgehend in diesen eindringende Nut 124 aufweist, welche durch Nutwände 126 und 128 begrenzt ist.

Vorzugsweise sind der netzseitige Stromanschlußträger 38, der masseseitige Stromanschlußträger 46 und der lastseitige Stromanschlußträger 42 derart angeordnet, daß deren Längsrichtungen 130, 132 und 134 im wesentlichen parallel zueinander verlaufen.

Die Leistungsschalter 30₁ bis 30₄ sind, wie in Fig. 4 dargestellt, so ausgebildet, daß diese Anschlußflansche 140₁ bis 140₄ aufweisen und mit diesen Anschlußflanschen 140₁ bis 140₄ an der Breitseite 82 der Profilschiene 70 anliegen. Damit liegen alle parallelgeschalteten Leistungsschalter 30₁ bis 30₄ in einer parallel zu den Längsrichtungen 130 und 134 der Stromanschlußträger 38, 42 verlaufenden Reihe 131.

Ferner weisen die Leistungsschalter 30₁ bis 30₄ jeweils mit dem lastseitigen Stromanschlußträger 42 zu verbindende Paare von Leiterstücken 142₁ bis 142₄ auf, wobei die Leiterstücke 142₁ bis 142₄ in die dem netzseitigen Stromanschlußträger 38 zugewandte Nut 124 der von dem lastseitigen Stromanschlußträger 42 umfaßten Profilschiene 120 eintauchen.

Um die einzelnen Paare von Leiterstücken 142₁ bis 142₄ in der Nut 124 zu fixieren, ist mindestens die Nutwand 128 durch sich von der Schmalseite 122 ausgehende Einschnitte 144 in Klemmbacken bildende Nutwandabschnitte 146₁ bis 146₄ unterteilt, so daß die einzelnen Nutwandabschnitte 146₁ bis 146₄ unabhängig voneinander in Richtung der Nutwand 126 biegbar sind, um das zwischen dem jeweiligen Nutwandabschnitt 146 und der Nutwand 126 liegenden Paar von Leiterstücken 142 zwischen der Nutwand 126 und dem jeweiligen Nutwandabschnitt 146 einzuklemmen.

Beispielsweise wird mit dem Nutwandabschnitt 146₁ das Paar von Leiterstücken 142₁ zwischen diesem und der Nutwand 126 eingeklemmt.

Zum Deformieren der Nutwandabschnitte 146₁ bis 146₄ und Einklemmen der Paare von Leiterstücken 142 ist jeder der Nutwandabschnitte 146 durch eine Spannschraube 148 beaufschlagbar, welche den Nutwandabschnitt 146 und die Nutwand 126 durchsetzt und beispielsweise beim Einschrauben in die Nutwandabschnitte 146 diese in Richtung der Nutwand 126 beaufschlagt.

Damit bildet jeder der Nutwandabschnitte 146₁ zusammen mit der Nutwand 126 eine Klemmverbindung 150₁ bis 150₄ deren Klemmbacken die Nutwände 126 und der jeweilige Nutwandabschnitt 146 darstellen und die Nut 124 die Aufnahme für die Leiterstücke 142 bildet.

Insgesamt stellt somit die Profilschiene 120 eine Aneinanderreihung von Klemmkörpern 152₁ bis 152₄ dar.

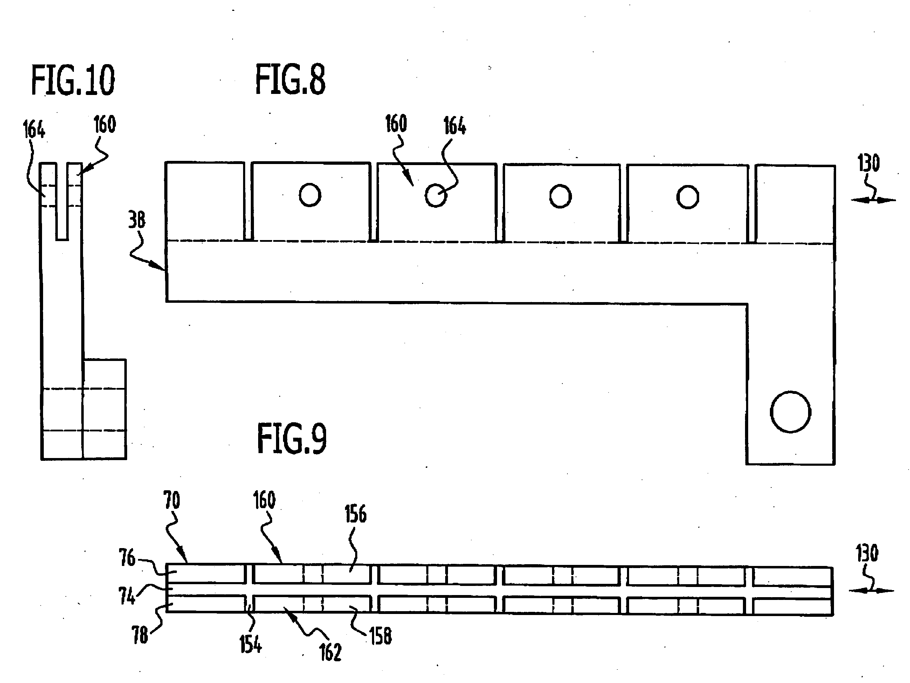

Wie in Fig. 8 bis 10 dargestellt, sind auch die Nutwände 76 und 78 der Profilschiene 70 durch die gesamte Profilschiene 70 quer zu ihrer Längsrichtung 130 durchsetzende Einschnitte 154 in Nutwandabschnitte 156 und 158 aufgeteilt, die jeweils eine Klemmverbindung 160 bilden, deren Klemmkörper 162 durch den jeweiligen Abschnitt der Profilschiene 70 gebildet ist, wobei eine Spannschraube 164 vorgesehen ist, um die Nutwandabschnitte 156 und 158 miteinander zu verspannen.

Jede dieser Klemmverbindungen 160 dient dazu, ein in Fig. 4 dargestelltes Leiterstück 166 von einem der Entstörkondensatoren 52₁ bis 52₄ einzuspannen und damit zu kontaktieren.

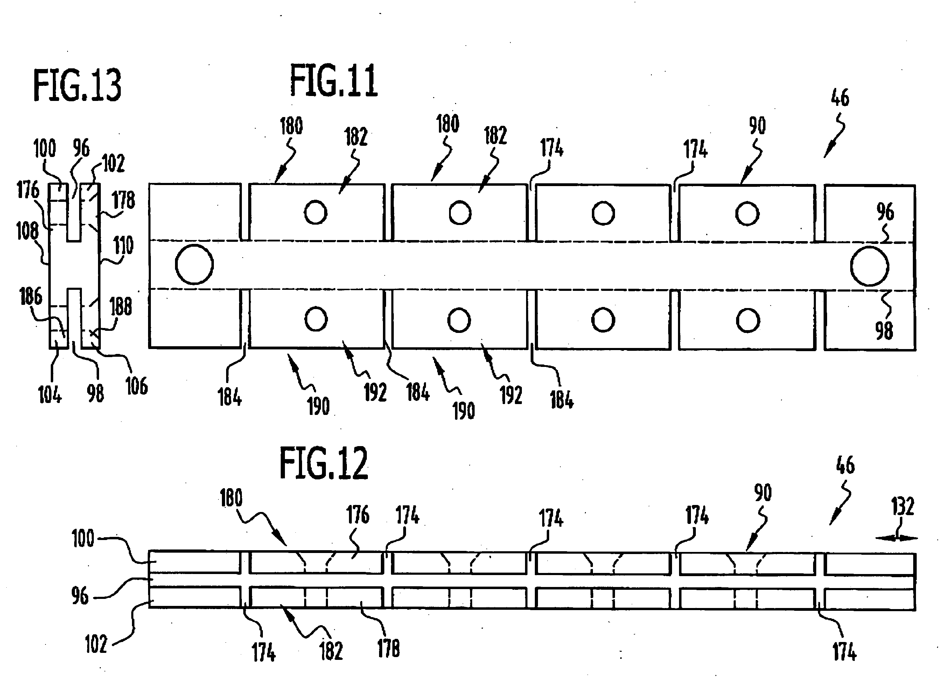

Ein anderes Leiterstück 168 der Entstörkondensatoren 52₁bis 52₄ ist, wie in Fig. 11 bis 13 dargestellt, in der Nut 96 der Profilschiene 90 einspannbar, wobei ebenfalls die Nutwände 100 und 102 durch Einschnitte 174 in Klemmbacken bildende Nutwandabschnitte 176, 178 unterteilt sind, welche eine Klemmverbindung 180 mit einem Klemmkörper 182 bilden, der durch eine Klemmschraube durch Zusammenziehen der Nutwandabschnitte 176 und 178 in der Lage ist, das Leiterstück 168 des jeweiligen Entstörkondensators 52₁ bis 52₄ einzuspannen.

Um die Entstörkondensatoren 52₁ bis 52₄ in einer parallel zu den Längsrichtungen 130 und 132 verlaufenden Reihe 133 anordnen zu können, liegen die Klemmkörper 162 und 182 ebenfalls in in den Längsrichtungen 130 und 132 verlaufenden Reihen in einem Abstand AB, welcher den Abstand der aus den Entstörkondensatoren 52₁ bis 52₄ austretenden Leiterstücke 166 und 168 entspricht, und die Aufnahme für die Leiterstücke 166 und 168 bildenden Nuten 74 und 96 sind der Reihe 133 der Entstörkondensatoren 52₁ bis 52₄ zugewandt.

Darüber hinaus sind auch die Nutwände 104 und 106 der Profilschiene 90 durch Einschnitte 184 in Klemmbacken bildende Nutwandabschnitte 186 und 188 unterteilt, welche somit in der Lage sind, Klemmverbindungen ,190 mit Klemmkörpern 192 zu bilden, wobei mit diesen Klemmverbindungen 190, wie in Fig. 3 dargestellt, Leiterstücke 194 der Freilaufdioden 48 einspannbar sind, die damit mit dem masseseitigen Stromanschlußträger 46 verbindbar sind und andererseits mit einem Anschlußflansch 196 an der Profilschiene 120 anliegen und mit dieser verbunden sind.

Vorzugsweise sind dabei die Anschlußflansche 196 ebenfalls mit der Profilschiene 120 verschraubt.

Somit liegen auch die Freilaufdioden 48₁ bis 48₄ in einer parallel zu den Längsrichtungen 132 und 134 verlaufenden Reihe 135.

Durch die erfindungsgemäße parallele Anordnung der Profilschienen 70, 90 und 120 und der in zu diesen parallelen Reihen 131, 133 und 135 angeordneten parallelgeschalteten Bauteile 30, 48, 52 ist eine kompakte und somit geringe Leitungslängen zwischen den einzelnen Bauteilen 30, 48, 52 erfordernde Bauweise der Leistungsendstufe 26 mit optimaler Entstörwirkung der Entstörkondensatoren 52 realisierbar.

## Patentansprüche

1. Steuereinrichtung für an einem elektrischen Versorgungsnetz (12, 14) eines Kraftfahrzeugs als Last (16, 18) angeschlossene Aggregate (20), umfassend einen Steuersignalgenerator (24) zur Erzeugung eines pulsweitenmodulierten Steuersignals (PWS1, PWS2), eine Leistungsendstufe (26, 28) mit mindestens einem Leistungsschalter (30, 32) zum Versorgen der jeweiligen Last (16, 18), wobei der Leistungsschalter (30, 32) durch das an einem Steuereingang (34, 36) desselben anliegende Steuersignal (PWS1, PWS2) pulsweitenmoduliert ansteuerbar ist und zur Verbindung mit dem Versorgungsnetz (12, 14) sowie mit der Last (16, 18) Anschlüsse (140, 142) aufweist,
**dadurch gekennzeichnet, dass** in der mindestens einen Leistungsendstufe (26, 28) ein netzseitiger Stromanschlussträger (38, 40) und ein lastseitiger Stromanschlussträger (42, 44) vorgesehen sind und dass mindestens ein Leiterstück (142) jedes Leistungsschalters (30, 32) durch jeweils eine durch Klemmbacken (126, 146;) eines Klemmkörpers (152) gebildete Klemmverbindung (150) mit einem der Stromanschlussträger (42) verbunden ist.

2. Steuereinrichtung nach Anspruch 1, **dadurch gekennzeichnet, dass** jeder der Leistungsschalter (30, 32) als weiteren Anschluss einen Anschlussflansch (140) aufweist und dass der Anschlussflansch (140) mit dem jeweils anderen Stromanschlussträger (38) verbunden ist.

3. Steuereinrichtung nach Anspruch 2, **dadurch gekennzeichnet, dass** der Anschlussflansch (140) an den jeweiligen Stromanschlussträger (38) angepresst anliegt.

4. Steuereinrichtung nach einem der voranstehenden Ansprüche, **dadurch gekennzeichnet, dass** die Klemmverbindung (150) eine dem anderen Stromanschlussträger (38) zugewandte Aufnahme (124) für das Leiterstück (142) aufweist.

5. Steuereinrichtung nach einem der voranstehenden Ansprüche, **dadurch gekennzeichnet, dass** der netzseitige Stromanschlussträger (38, 40) und der lastseitige Stromanschlussträger (42, 44) parallel zueinander verlaufen.

6. Steuereinrichtung nach Anspruch 5, **dadurch gekennzeichnet, dass** eine Vielzahl von parallelgeschalteten Leistungsschaltern (30, 32) vorgesehen ist, welche in einer parallel zu den Stromanschlussträgenn (38, 40, 42, 44) verlaufenden Reihe (131) angeordnet sind.

7. Steuereinrichtung nach einem der voranstehenden Ansprüche, **dadurch gekennzeichnet, dass** ein masseseitiger Stromanschlussträger (46) vorgesehen ist und dass zwischen dem netzseitigen Stromanschlussträger (38) und dem masseseitigen Stromanschlussträger (46) mindestens ein Entstörkondensator (52, 54) vorgesehen ist.

8. Steuereinrichtung nach Anspruch 7, **dadurch gekennzeichnet, dass** der mindestens eine Entstörkondensator (52) zwei Kondensatoranschlüsse (166, 168) aufweist, von denen mindestens einer als Leiterstück (166) ausgebildet und durch mindestens eine Klemmverbindung (160) mit einem (38) der Stromanschlussträger (38, 46) verbunden ist.

9. Steuereinrichtung nach Anspruch 8, **dadurch gekennzeichnet, dass** der andere Kondensatoranschluss als Leiterstück (168) ausgebildet ist und durch jeweils eine Klemmverbindung (180) mit dem anderen (46) der Stromanschlussträger (38, 46) verbunden ist.

10. Steuereinrichtung nach einem der Ansprüche 7 bis 9, **dadurch gekennzeichnet, dass** der netzseitige Stromanschlussträger (38) und der masseseitige Stromanschlussträger (46) mit Abstand nebeneinanderliegend angeordnet sind.

11. Steuereinrichtung nach Anspruch 10, **dadurch gekennzeichnet, dass** die Klemmverbindungen (160, 180) mit ihren Aufnahmen (76, 96) für die Leiterstücke an den Stromanschlussträgem (38, 46) in einem Abstand (AB) angeordnet sind, welcher ungefähr einem Abstand der aus dem mindestens einen Entstörkondensator (52, 54) austretenden Leiterstücke (166, 168) entspricht.

12. Steuereinrichtung nach Anspruch 10 oder 11, **dadurch gekennzeichnet, dass** der netzseitige Stromanschlussträger (38) und der masseseitige Stromanschlussträger (46) durch einen Isolierkörper (84) gegeneinander elektrisch isoliert sind.

13. Steuereinrichtung nach einem der Ansprüche 4 bis 9, **dadurch gekennzeichnet, dass** mehrere Entstörkondensatoren (52, 54) in einer zu den Stromanschlussträgem (38, 46) parallel verlaufenden Reihe (133) angeordnet sind.

14. Steuereinrichtung nach einem der voranstehenden Ansprüche, **dadurch gekennzeichnet, dass** ein masseseitiger Stromanschlussträger (46) vorgesehen ist, und dass zwischen dem lastseitigen Stromanschlussträger (42, 44) und dem masseseitigen Stromanschlussträger (46) mindestens eine Freilaufdiode (48, 50) vorgesehen ist.

15. Steuereinrichtung nach Anspruch 14, **dadurch gekennzeichnet, dass** die mindestens eine Freilaufdiode (48) zwei Diodenanschlüsse (194, 196) aufweist und dass mindestens einer der Diodenanschlüsse (194, 196) als Leiterstück (194) ausgebildet und durch jeweils eine Klemmverbindung (190) mit einem (46) der Stromanschlussträger (42, 46) verbunden ist.

16. Steuereinrichtung nach Anspruch 15, **dadurch gekennzeichnet, dass** der andere Diodenanschluss als Anschlussflansch (196) ausgebildet und über diesen mit dem jeweils anderen Stromanschlussträger (42) verbunden ist.

17. Steuereinrichtung nach Anspruch 16, **dadurch gekennzeichnet, dass** der Anschlussflansch (196) an dem jeweiligen Stromanschlussträger (42) angepresst anliegt.

18. Steuereinrichtung nach einem der Ansprüche 15 bis 17, **dadurch gekennzeichnet, dass** die Klemmverbindung (190) eine dem anderen Stromanschlussträger (38) zugewandte Aufnahme (98) aufweist.

19. Steuereinrichtung nach einem der Ansprüche 15 bis 18, **dadurch gekennzeichnet, dass** der lastseitige Stromanschlussträger (42, 44) und der masseseitige Stromanschlussträger (46) parallel zueinander verlaufen.

20. Steuereinrichtung nach Anspruch 19, **dadurch gekennzeichnet, dass** eine Vielzahl von parallelgeschalteten Freilaufdioden (48, 50) vorgesehen ist, welche in einer parallel zu den Stromanschlussträgern (42, 44, 46) verlaufenden Reihe (133) angeordnet sind.

21. Steuereinrichtung nach einem der Ansprüche 8 bis 20, **dadurch gekennzeichnet, dass** die Klemmverbindung (160, 180, 190) durch Klemmbacken (156, 1,58; 176, 178; 186, 188) eines Klemmkörpers (162, 182, 192) gebildet ist.

22. Steuereinrichtung nach einem der voranstehenden Ansprüche, **dadurch gekennzeichnet, dass** die Klemmbacken (126, 146; 156, 158; 176, 178; 186, 188) einstückig an den Klemmkörper (152, 162, 182, 192) angeformt sind.

23. Steuereinrichtung nach Anspruch 22, **dadurch gekennzeichnet, dass** der Klemmkörper (152, 162, 182, 192) durch einen Abschnitt einer Profilschiene (70, 90, 120) gebildet ist, welche mindestens eine Nut (74, 96, 98, 124) aufweist und mit beiderseits der Nut (74, 96, 98, 124) angeordneten Nutwänden Klemmbacken (126, 146; 156, 158; 176, 178; 186, 188) bildet.

24. Steuereinrichtung nach einem der voranstehenden Ansprüche, **dadurch gekennzeichnet, dass** jeder Stromanschlussträger (38, 42, 46) mit einer Vielzahl von Klemmkörpern (152, 162, 182, 192) versehen ist.

25. Steuereinrichtung nach einem der voranstehenden Ansprüche, **dadurch gekennzeichnet, dass** der Stromanschlussträger (38, 42, 46) selbst als die Klemmkörper (152, 162, 182, 192) bildende Profilschiene (70, 90, 120) ausgebildet ist.

26. Steuereinrichtung nach Anspruch 24 oder 25, **dadurch gekennzeichnet, dass** die Vielzahl von Klemmkörpern (152, 162, 182, 192) durch auf mindestens einer Seite der Nut (74, 96, 98, 124) angeordnete getrennte Nutwandabschnitte (146, 156, 158, 176, 178, 186, 188) gebildet ist,

27. Steuereinrichtung nach Anspruch 26, **dadurch gekennzeichnet, dass** die Nutwandabschnitte (146, 156, 158, 176, 178, 186, 188) durch in der jeweiligen Nutwand (76, 78, 100, 102, 104, 106, 126, 128) quer zur Längsrichtung (130, 132, 134) der Nut (74, 96, 98, 124) verlaufende Einschnitte (144, 154, 174, 184) gebildet sind.

28. Steuereinrichtung nach einem der voranstehenden Ansprüche, **dadurch gekennzeichnet, dass** eine Masseverbindung von dem Versorgungsnetz (12, 14) zu einem die Last (16, 18) aufweisenden Aggregat (20) ausschließlich über die Leistungsendstufe (26, 28) der Steuereinrichtung (10) geführt ist.

29. Steuereinrichtung nach Anspruch 28, **dadurch gekennzeichnet, dass** die Masseverbindung über einen masseseitigen Stromanschlussträger (46) der Steuereinrichtung (10) geführt ist.

30. Steuereinrichtung nach Anspruch 29, **dadurch gekennzeichnet, dass** von dem Versorgungsnetz (12, 14) eine Masseleitung (58) zum masseseitigen Stromanschlussträger (46) und vom masseseitigen Stromanschlussträger (46) eine Masseleitung (60) zu dem die Last (16, 18) aufweisenden Aggregat (20) geführt ist.

## Claims

1. Control device for units (20) connected to an electric supply network (12, 14) of a motor vehicle as load (16, 18), comprising a control signal generator (24) for generating a pulse-width modulated control signal (PWS1, PWS2), a power output stage (26, 28) with at least one power switch (30, 32) for supplying the respective load (16, 18), wherein the power switch (30, 32) is activatable in a pulse-width modulated manner by the control signal (PWS1, PWS2) applied to a control input (34, 36) thereof and has connections (140, 142) for connection to the supply network (12, 14) and to the load (16, 18), **characterized in that** a current connection carrier (38, 40) on the network side and a current connection carrier (42, 44) on the load side are provided in the at least one power output stage (26, 28), and **in that** at least one conductor element (142) of each power switch (30, 32) is connected to one of the current connection carriers (42) by a respective clamping connection (150) formed by clamping jaws (126, 146) of a clamping member (152).

2. Control device as defined in claim 1, **characterized in that** each of the power switches (30, 32) has a connection flange (140) as further connection, and **in that** the connection flange (140) is connected to the respective other current connection carrier (38).

3. Control device as defined in claim 2, **characterized in that** the connection flange (140) abuts in a pressed manner on the respective current connection carrier (38).

4. Control device as defined in any one of the preceding claims, **characterized in that** the clamping connection (150) has a receptacle (124) for the conductor element (142), which faces the other current connection carrier (38).

5. Control device as defined in any one of the preceding claims, **characterized in that** the current connection carrier (38, 40) on the network side and the current connection carrier (42, 44) on the load side extend parallel to one another.

6. Control device as defined in claim 5, **characterized in that** a plurality of power switches (30, 32) connected in parallel are provided, which are arranged in a row (131) extending parallel to the current connection carriers (38, 40, 42, 44).

7. Control device as defined in any one of the preceding claims, **characterized in that** a current connection carrier (46) on the ground side is provided, and **in that** at least one interference suppression capacitor (52, 54) is provided between the current connection carrier (38) on the network side and the current connection carrier (46) on the ground side.

8. Control device as defined in claim 7, **characterized in that** the at least one interference suppression capacitor (52) has two capacitor connections (166, 168), at least one of which is designed as a conductor element (166) and is connected to one (38) of the current connection carriers (38, 46) by at least one clamping connection (160).

9. Control device as defined in claim 8, **characterized in that** the other capacitor connection is designed as a conductor element (168) and is connected to the other one (46) of the current connection carriers (38, 46) by a respective clamping connection (180).

10. Control device as defined in any one of claims 7 to 9, **characterized in that** the current connection carrier (38) on the network side and the current connection carrier (46) on the ground side are arranged so as to lie next to and in spaced relationship to one another.

11. Control device as defined in claim 10, **characterized in that** the clamping connections (160, 180) with their receptacles (76, 96) for the conductor elements are arranged on the current connection carriers (38, 46) at a spacing (AB) which corresponds approximately to a spacing between the conductor elements (166, 168) exiting from the at least one interference suppression capacitor (52, 54).

12. Control device as defined in claim 10 or 11, **characterized in that** the current connection carrier (38) on the network side and the current connection carrier (46) on the ground side are electrically insulated from one another by an insulating member (84).

13. Control device as defined in any one of claims 4 to 9, **characterized in that** several interference suppression capacitors (52, 54) are arranged in a row (133) extending parallel to the current connection carriers (38, 46).

14. Control device as defined in any one of the preceding claims, **characterized in that** a current connection carrier (46) on the ground side is provided, and **in that** at least one free-wheeling diode (48, 50) is provided between the current connection carrier (42, 44) on the load side and the current connection carrier (46) on the ground side.

15. Control device as defined in claim 14, **characterized in that** the at least one freewheeling diode (48) has two diode connections (194, 196), and **in that** at least one of the diode connections (194, 196) is designed as a conductor element (194) and is connected to one (46) of the current connection carriers (42, 46) by a respective clamping connection (190).

16. Control device as defined in claim 15, **characterized in that** the other diode connection is designed as a connection flange (196) and is connected via it to the respective other current connection carrier (42).

17. Control device as defined in claim 16, **characterized in that** the connection flange (196) abuts in a pressed manner on the respective current connection carrier (42).

18. Control device as defined in any one of claims 15 to 17, **characterized in that** the clamping connection (190) has a receptacle (98) which faces the other current connection carrier (38).

19. Control device as defined in any one of claims 15 to 18, **characterized in that** the current connection carrier (42, 44) on the load side and the current connection carrier (46) on the ground side extend parallel to one another.

20. Control device as defined in claim 19, **characterized in that** a plurality of freewheeling diodes (48, 50) connected in parallel are provided, which are arranged in a row (133) extending parallel to the current connection carriers (42, 44, 46).

21. Control device as defined in any one of claims 8 to 20, **characterized in that** the clamping connection (160, 180, 190) is formed by clamping jaws (156, 158; 176, 178; 186, 188) of a clamping member (162, 182, 192).

22. Control device as defined in any one of the preceding claims, **characterized in that** the clamping jaws (126, 146; 156, 158; 176, 178; 186, 188) are integrally formed on the clamping member (152, 162, 182, 192).

23. Control device as defined in claim 22, **characterized in that** the clamping member (152, 162, 182, 192) is formed by a section of a profiled rail (70, 90, 120) which has at least one groove (74, 96, 98, 124) and forms with groove walls arranged on both sides of the groove (74, 96, 98, 124) clamping jaws (126, 146; 156, 158; 176, 178; 186, 188).

24. Control device as defined in any one of the preceding claims, **characterized in that** each current connection carrier (38, 42, 46) is provided with a plurality of clamping members (152, 162, 182, 192).

25. Control device as defined in any one of the preceding claims, **characterized in that** the current connection carrier (38, 42, 46) itself is designed as a profiled rail (70, 90, 120) forming the clamping members (152, 162, 182, 192).

26. Control device as defined in claim 24 or 25, **characterized in that** the plurality of clamping members (152, 162, 182, 192) are formed by separate groove wall sections (146, 156, 158, 176, 178, 186, 188) arranged on at least one side of the groove (74, 96, 98, 124).

27. Control device as defined in claim 26, **characterized in that** the groove wall sections (146, 156, 158, 176, 178, 186, 188) are formed by slits (144, 154, 174, 184) extending in the respective groove wall (76, 78, 100, 102, 104, 106, 126, 128) transversely to the longitudinal direction (130, 132, 134) of the groove (74, 96, 98, 124).

28. Control device as defined in any one of the preceding claims, **characterized in that** a ground connection from the supply network (12, 14) to a unit (20) comprising the load (16, 18) is guided exclusively via the power output stage (26, 28) of the control device (10).

29. Control device as defined in claim 28, **characterized in that** the ground connection is guided via a current connection carrier (46) of the control device (10) on the ground side.

30. Control device as defined in claim 29, **characterized in that** a ground line (58) is guided from the supply network (12, 14) to the current connection carrier (46) on the ground side, and a ground line (60) is guided from the current connection carrier (46) on the ground side to the unit (20) comprising the load (16, 18).

## Revendications

1. Dispositif de commande pour des agrégats (20) raccordés en tant que résistances de charge (16, 18) à un réseau d'alimentation (12, 14) électrique d'un véhicule automobile, comportant un générateur de signaux de commande (24) destiné à générer un signal de commande à modulation des impulsions en largeur (PWS1, PWS2), un étage de sortie de puissance (26, 28) avec au moins un sectionneur de puissance (30, 32) destiné à alimenter la résistance de charge (16, 18) respective, le sectionneur de puissance (30, 32) pouvant être commandé par modulation des impulsions en largeur de signal de commande (PWS1, PWS2) appliqué à une entrée de commande (34, 36), et présentant des raccordements (140, 142) pour le raccordement au réseau d'alimentation (12, 14) ainsi qu'à la résistance de charge (16, 18),
**caractérisé en ce que**, dans l'étage de sortie de puissance (26, 28) au moins au nombre de un, on prévoit une borne de connexion électrique côté réseau (38, 40) et une borne de connexion électrique côté résistance de charge (42, 44), et **en ce qu'**au moins un élément conducteur (142) de chaque sectionneur de puissance (30, 32) est relié respectivement, par une jonction par serrage (150) formée par des mâchoires de serrage (126, 146) d'un corps de serrage (152), à l'une des bornes de connexion électrique (42).

2. Dispositif de commande selon la revendication 1, **caractérisé en ce que** chacun des sectionneurs de puissance (30, 32) présente une bride de raccordement (140) comme autre raccordement, et **en ce que** la bride de raccordement (140) est respectivement reliée à l'autre borne de connexion électrique (38).

3. Dispositif de commande selon la revendication 2, **caractérisé en ce que** la bride de raccordement (140) repose de manière pressée contre la borne de connexion électrique (38) respective.

4. Dispositif de commande selon l'une quelconque des revendications précédentes, **caractérisé en ce que** la jonction par serrage (150) présente un logement (124) tourné vers l'autre borne de connexion électrique (38) pour l'élément conducteur (142).

5. Dispositif de commande selon l'une quelconque des revendications précédentes, **caractérisé en ce que** la borne de connexion électrique côté réseau (38, 40) et la borne de connexion électrique côté résistance de charge (42, 44) s'étendent parallèlement l'une par rapport à l'autre.

6. Dispositif de commande selon la revendication 5, **caractérisé en ce qu'**une pluralité de sectionneurs de puissance (30, 32) couplés en parallèle sont prévus, lesquels sont disposés sur une rangée (131) s'étendant de manière parallèle par rapport aux bornes de connexion électriques (38, 40, 42, 44).

7. Dispositif de commande selon l'une quelconque des revendications précédentes, **caractérisé en ce qu'**une borne de connexion électrique côté masse (46) est prévue, et en qu'il est prévu, entre la borne de connexion électrique côté réseau (38) et la borne de connexion électrique côté résistance de masse (46), au moins un condensateur d'antiparasitage (52, 54).

8. Dispositif de commande selon la revendication 7, **caractérisé en ce que** le condensateur d'antiparasitage (52) au moins au nombre de un présente deux raccordements de condensateur (166, 168), au moins l'un d'entre eux étant réalisé en tant qu'élément conducteur (166) et étant relié, par au moins une jonction par serrage (160), à l'une des bornes de connexion électrique (38, 46).

9. Dispositif de commande selon la revendication 8, **caractérisé en ce que** l'autre raccordement de condensateur est réalisé en tant qu'élément conducteur (168) et est relié, par respectivement une jonction par serrage (180), à l'autre (46) borne parmi les bornes de connexion électrique (38, 46).

10. Dispositif de commande selon l'une quelconque des revendications 7 à 9, **caractérisé en ce que** la borne de connexion électrique côté réseau (38) et la borne de connexion électrique côté résistance de masse (46) sont disposées à distance l'une à côté de l'autre.

11. Dispositif de commande selon la revendication 10, **caractérisé en ce que** les jonctions par serrage (160, 180) avec leurs logements (76, 96) pour les éléments conducteurs sont disposées au niveau des bornes de connexion électrique (38, 46) à une distance (AB), laquelle correspond environ à une distance des éléments conducteurs (166, 168) sortant du condensateur d'antiparasitage (52, 54) au moins au nombre de un.

12. Dispositif de commande selon la revendication 10 ou 11, **caractérisé en ce que** la borne de connexion électrique côté réseau (38) et la borne de connexion électrique côté résistance de masse (46) sont isolées électriquement l'une par rapport à l'autre par un corps isolant (84).

13. Dispositif de commande selon l'une quelconque des revendications 4 à 9, **caractérisé en ce que** plusieurs condensateurs d'antiparasitage (52, 54) sont disposés sur une ligne (133) s'étendant de manière parallèle par rapport aux bornes de connexion électrique (38, 46).

14. Dispositif de commande selon l'une quelconque des revendications précédentes, **caractérisé en ce qu'**une borne de connexion électrique côté masse (46) est prévue, et **en ce qu'**il est prévu au moins une diode de roue libre (48, 50) entre la borne de connexion électrique côté charge (42, 44) et la borne de connexion électrique côté masse (46).

15. Dispositif de commande selon la revendication 14, **caractérisé en ce que** la diode de roue libre (48) présente deux raccordements de diode (194, 196), et **en ce qu'**au moins un des raccordements de diode (194, 196) est réalisé en tant qu'élément conducteur (194) et est relié respectivement, par une jonction par serrage (190), à l'une (46) des bornes de connexion électrique (42, 46).

16. Dispositif de commande selon la revendication 15, **caractérisé en ce que** l'autre raccordement de diode est réalisé en tant que bride de raccordement (196) et est relié respectivement, par celle-ci, à l'autre borne de connexion électrique (42).

17. Dispositif de commande selon la revendication 16, **caractérisé en ce que** la bride de raccordement (196) repose de manière pressée contre la borne de connexion électrique (42) respective.

18. Dispositif de commande selon l'une quelconque des revendications 15 à 17, **caractérisé en ce que** la jonction par serrage (190) présente un logement (98) tourné vers l'autre borne de connexion électrique (38).

19. Dispositif de commande selon l'une quelconque des revendications 15 à 18, **caractérisé en ce que** la borne de connexion électrique côté charge (42, 44) et la borne de connexion électrique côté masse (46) s'étendent de manière parallèle l'une par rapport à l'autre.

20. Dispositif de commande selon la revendication 19, **caractérisé en ce qu'**une pluralité de diodes de roue libre (48, 50) couplées en parallèle sont prévues, lesquelles sont disposées sur une rangée (133) s'étendant de manière parallèle par rapport aux bornes de connexion électriques (42, 44, 46).

21. Dispositif de commande selon l'une quelconque des revendications 8 à 20, **caractérisé en ce que** la jonction par serrage (160, 180, 190) est formée par des mâchoires de serrage (156, 158 ; 176, 178 ; 186, 188) d'un corps de serrage (162, 182, 192).

22. Dispositif de commande selon l'une quelconque des revendications précédentes, **caractérisé en ce que** les mâchoires de serrage (126, 146 ; 156, 158 ; 176, 178 ; 186, 188) sont formées d'un seul tenant sur le corps de serrage (152, 162, 182, 192).

23. Dispositif de commande selon la revendication 22, **caractérisé en ce que** le corps de serrage (152, 162, 182, 192) est formé par un segment d'une barre profilée (70, 90, 120), laquelle présente au moins une rainure (74, 96, 98, 124) et forme des mâchoires de serrage (126, 146 ; 156, 158 ; 176, 178 ; 186, 188) avec des parois de rainure disposées des deux côtés de la rainure (74, 96, 98, 124).

24. Dispositif de commande selon l'une quelconque des revendications précédentes, **caractérisé en ce que** chaque borne de connexion électrique (38, 42, 46) est munie d'une pluralité de corps de serrage (152, 162, 182, 192).

25. Dispositif de commande selon l'une quelconque des revendications précédentes, **caractérisé en ce que** la borne de connexion électrique (38, 42, 46) elle-même est réalisée en tant que barre profilée (70, 90, 120) formant les corps de serrage (152, 162, 182, 192).

26. Dispositif de commande selon la revendication 24 ou 25, **caractérisé en ce que** la pluralité des corps de serrage (152, 162, 182, 192) est formée par des segments de paroi de rainure séparés (146, 156, 158, 176, 186, 188) disposés sur au moins un côté de la rainure (74, 96, 98, 124).

27. Dispositif de commande selon la revendication 26, **caractérisé en ce que** les segments de paroi de rainure (146, 156, 158, 176, 186, 188) sont formés par des entailles (144, 154, 174, 184) s'étendant de manière transversale par rapport à la direction longitudinale (130, 132, 134) de la rainure (74, 96, 98, 124) dans la paroi de rainure (76, 78, 100, 102, 104, 106, 126, 128) respective.

28. Dispositif de commande selon l'une quelconque des revendications précédentes, **caractérisé en ce qu'**une liaison de mise à la masse depuis le réseau d'alimentation (12, 14) jusqu'à un agrégat (20) présentant la résistance de charge (16, 18) passe exclusivement par l'étage de sortie de puissance (26, 28) du dispositif de commande (10).

29. Dispositif de commande selon la revendication 28, **caractérisé en ce que** la liaison de mise à la masse passe par une borne de connexion électrique côté masse (46) du dispositif de commande (10).

30. Dispositif de commande selon la revendication 29, **caractérisé en ce qu'**un câble de masse (58) s'étend du réseau d'alimentation (12, 14) vers la borne de connexion électrique côté masse (46), et **en ce qu'**un câble de masse (60) s'étend de la borne de connexion électrique côté masse (46) vers l'agrégat (20) présentant la résistance de charge (16, 18).
